# EUROPEAN PATENT SPECIFICATION

(11) **EP 2 036 860 B1**
(45) Date of publication and mention of the grant of the patent: **02.03.2016**
(21) Application number: 06757080.4
(22) Date of filing: 06.06.2006
(51) Int. Cl.: C01G 49/00, C08L 63/00, H01L 23/29, H01L 23/31, C04B 35/26, C04B 35/626, C08G 59/62, C09C 1/24, H01L 23/552, H01L 23/00

(54) **SPHERICAL SINTERED FERRITE PARTICLE, SEMICONDUCTOR SEALING RESIN COMPOSITION MAKING USE OF THE SAME AND SEMICONDUCTOR DEVICE OBTAINED THEREWITH**
SPHÄRISCHES GESINTERTES FERRITTEILCHEN, HALBLEITERVERSIEGELUNGSHARZMASSE DAMIT UND DAMIT ERHALTENE HALBLEITERVORRICHTUNG
PARTICULE DE FERRITE FRITTÉE SPHÉRIQUE, COMPOSITION DE RÉSINE DE SCELLEMENT À SEMI-CONDUCTEURS L'UTILISANT ET DISPOSITIF À SEMI-CONDUCTEURS OBTENU AVEC

(43) Date of publication of application: 18.03.2009
(73) Proprietor: NITTO DENKO CORPORATION, Ibaraki-shi, Osaka 567-8680 (JP); TODA KOGYO CORPORATION, Otake-shi Hiroshima (JP)
(72) Inventor: YAMAMOTO, Kazumi, Hiroshima (JP); ABE, Masaharu, Hiroshima (JP); YAMAMOTO, Shigehisa, Hiroshima (JP); NISHIMOTO, Kazushi, Hiroshima (JP); DOTE, Tomohiro, Hiroshima (JP); IGARASHI, Kazumasa, Osaka (JP); IKEMURA, Kazuhiro, Osaka (JP); ETO, Takuya, Osaka (JP); TADA, Masataka, Osaka (JP); OKAYAMA, Katsumi, Tokyo (JP); KOBAYASHI, Kaoru, Kanagawa (JP)
(74) Representative: Grünecker Patent- und Rechtsanwälte PartG mbB
(86) International application number: PCT/JP2006/311342
(87) International publication number: WO 2007/141843

(56) References cited:
- EP-A1- 1 595 919
- JP-A- 8 295 517
- JP-A- 05 308 016
- JP-A- 2000 214 658
- JP-A- 2002 110 863
- JP-A- 2002 363 382
- JP-A- 2005 109 181
- JP-A- 2005 139 050
- JP-A- 2005 139 050
- JP-A- 2005 194 431
- US-A1- 2003 024 723
- ARUJ RAJ I ET AL: "ON THE SUITABILITY OF LA0.60SR0.40CO0.20FE0.80O3 CATHODE FOR THE INTERMEDIATE TEMPERATURE SOLID OXID FUEL CELL (ITSOFC)", JOURNAL OF NEW MATERIALS FOR ELECTROCHEMICAL SYSTEMS, ECOLE POLYTECHNIQUE DE MONTREAL, MONTREAL, CA, vol. 7, no. 2, 1 April 2004 (2004-04-01), pages 145-151, XP001503512, ISSN: 1480-2422

## Description

### Technical Field

The present invention relates to spherical sintered ferrite particles of good electromagnetic wave shieldability, to a resin composition for semiconductor encapsulation comprising them, which is to be a cured body-forming material having both good electromagnetic wave shieldability and good electric insulation properties, and to a semiconductor device of high reliability produced with the resin composition.

### Background Art

In general, in a process of producing semiconductor devices, the semiconductor element finished after bonding to a substrate is encapsulated with a molding resin such as a thermosetting resin for preventing it from being in contact with the outside. The molding resin is prepared, for example, by mixing and dispersing a silica powder-based inorganic filler in an epoxy resin. Regarding the method of encapsulation with the molding resin, for example, a transfer molding method has been put into practical use, which comprises putting a semiconductor element bonded to a substrate into a mold, transferring a molding resin thereinto under pressure and curing and molding the molding resin therein.

Heretofore, resin-encapsulated semiconductor devices fabricated by encapsulating a semiconductor element with a molding resin are excellent in point of the reliability, the mass-producibility, and the cost thereof, and have become much used in the art along with ceramic-encapsulated semiconductor devices that comprise ceramics as the constitutive material thereof.

With electric appliances, a problem of electromagnetic compatibility (EMC) has been specifically noted. For example, recent information communication appliances are being toward much more down-sized and function-advanced ones, and for further improving the performance of semiconductor devices to be used in such appliances, the signal amplitude is reduced so as to lower the power consumption. As a result, there is increasing a possibility that even minor high-frequency noises may cause malfunction of semiconductor devices. Accordingly, development of electronic devices not releasing any unnecessary electromagnetic waves or resistant to electromagnetic waves generated around them is being promoted.

In general, when a cured product of a resin composition for semiconductor encapsulation has absorbed electromagnetic waves, then it converts the energy of the waves into heat. The energy conversion efficiency is correlated with the values of the imaginary part ε" of the complex dielectric constant of the dielectric constant of the cured resin as complex expression, and the imaginary part µ" of the complex magnetic permeability of the magnetic permeability thereof as complex expression. These values each indicate the dielectric loss and the magnetic loss, respectively, of the incident electromagnetic energy; and when these values are larger, then the energy conversion efficiency is higher, and therefore the electromagnetic wave shieldability is higher.

One method of solving the above-mentioned electromagnetic interference problem is proposed, which comprises building a semiconductor element-containing integrated circuit device in a package case equipped with a package base and a package cap formed of ferrite or of a substance having ferrite-corresponding characteristics followed by airtightly encapsulating it therein so as to make the case absorb electromagnetic waves inside and outside it (see Patent Reference 1).

Also proposed is a resin-encapsulated semiconductor device, which comprises a semiconductor element bonded onto a die pad and a wire connected to the semiconductor element and a lead, and in which the wire, the semiconductor element and a part of the lead are encapsulated with a magnetic resin (see Patent Reference 2). In this case, the surface of the semiconductor device is coated with a ferrite-dispersedmagnetic resin to form a two-layered resin-encapsulated structure, or ferrite is used in place of the silica particles to be used as a filler in the molding resin, thereby forming a one-layered resin-encapsulated structure.

Also proposed is a semiconductor package for casing a semiconductor element and other elements therein, of which the semiconductor package body is formed of a magnetic powder-mixed plastic resin (see Patent Reference 3). The plastic resin comprises a magnetic powder such as ferrite or amorphous alloy mixed therein, in which the amount of the magnetic powder is preferably from 30 to 60 % by weight or so. If the amount is smaller than 30 % by weight, then the resin may be ineffective for preventing electromagnetic noises; but even if larger than 60 % by weight, the effect of the magnetic powder is saturated.

Also proposed is a semiconductor device comprising a semiconductor part, a wire metal substrate to which the part is bonded and a molding resin to directly cover the part and the necessary area of the metal substrate, in which the molding resin comprises an organic resin and from 35 to 95 % by weight of a ferrite powder added thereto, and the thermal expansion coefficient of the molding resin is from 14 to 20 ppm/°C (see Patent Reference 4). The molding resin may comprise an epoxy resin and a substance of a formula, MFe₂O₄ or MO·nFe₂O₃ (wherein M is a divalent metal, and n is an integer) added thereto as a ferrite powder.

Also proposed is a resin composition for semiconductor encapsulation comprising a thermosetting epoxy resin, a phenolic resin-based curing agent for the epoxy resin, a silica powder and a magnetic powder serving as a filler for the epoxy resin, wherein the mean particle size of the silica powder is smaller than that of the magnetic powder (see Patent Reference 5). This is characterized in that the magnetic powder is ferrite of which the mean particle size is from 10 to 50 µm and the largest particle size is at most 200 µm.

Also proposed is an epoxy resin composition comprising, as the indispensable ingredients thereof, (A) an epoxy resin, (B) a curing agent, (C) a magnetic powder and (d) a curing accelerator, in which the magnetic powder (C) has a relative magnetic permeability of from 50 to 3000 and its content is from 30 to 90 % by volume of the overall epoxy resin composition (see Patent Reference 6). Preferably, the relative magnetic permeability of the magnetic powder (C) is higher; and if it is less than 50, then the complex magnetic permeability of the resin composition is low and the electromagnetic wave shieldability thereof may be insufficient. For the magnetic powder (C), preferred is a ferrite-based powder; and Ni-Zn-based ferrite or Mn-Zn-based ferrite may be preferably used in spinel type, and Zr-Mn-based ferrite or Ti-Mn-based ferrite may be preferably in magnetoplumbite type.
Patent Reference 1 JP-A-64-41248
Patent Reference 2 JP-A-3-23654
Patent Reference 3 JP-A-6-151626
Patent Reference 4 JP-A-11-40708
Patent Reference 5 JP-A-2002-363382
Patent Reference 6 JP-A-2003-128880

JP-A-2005-139050 discloses a resin composition for semiconductor encapsulation comprising a filler containing ferrite particles having a unimodal particle size distribution, and silica particles.

### Disclosure of the Invention

### Problems that the Invention is to Solve

However, the semiconductor package with ferrite in Patent Reference 1 is difficult to work and is not practicable in point of its cost. Therefore, a method of semiconductor encapsulation with ferrite is desired, which is simple and easy and which is more effective and more reliable for solution of electromagnetic interference problems.

In Patent Reference 2, a semiconductor device having a one-layered resin structure is easily produced, using ferrite as a filler for the molding resin, and the device is prevented from malfunctioning with electromagnetic noises. In this, however, since the ferrite-containing resin is in direct contact with the semiconductor element, the resin composition that contains an ordinary ferrite having many soluble ions is problematic in its reliability. Further, also in Patent Reference 3, the device is problematic in its reliability since a semiconductor element and others are encapsulated through direct molding with a magnetic substance-mixed plastic material.

In Patent Reference 4, the reliability is increased by the use of a molding resin containing from 35 to 95 % by weight of a ferrite powder added thereto and having a thermal expansion coefficient of from 14 to 20 ppm/°C. However, this reference does not disclose the moldability and the dielectric breakdown property of the resin as well as the short-circuit test result with the resin under a load of bias voltage applied thereto, in which, therefore, there are some problems in point of the moldability of the molding resin having a high ferrite content and of the reliability thereof under a load of bias voltage applied thereto.

In Patent Reference 5, the inventors specifically noted the moldability of a ferrite powder-mixed molding resin and the risk of malfunction through current leakage owing to the contact between a semiconductor element and the cured product of the molding resin, and proposed a resin composition for semiconductor encapsulation that contains a specific silica powder and a specific ferrite-based magnetic powder, as so mentioned hereinabove; however, the resin composition is still unsatisfactory in point of the reliability thereof in practical use.

In Patent Reference 6, proposed is an epoxy resin composition for semiconductor encapsulation, which contains a magnetic powder having a high magnetic permeability of from 50 to 3000. However, of ferrite-based powders that are said to be preferred for use therein, the magnetic permeability of those having a high magnetic permeability may be at most 30 or so; and, in fact, therefore, the powders are far from those capable of satisfying the requirement of the invention in this reference. In this, in addition, nothing is referred to relating to the reliability of ferrite, and its use is problematic.

The molding resin in a resin composition for semiconductor encapsulation must have a low viscosity up to the molding temperature thereof because of its requirement for low-pressure transfermoldability, and it is required to have high flowability. In such a molding resin system, ground Mn-Zn-based ferrite and Ni-Zn-based ferrite prepared by mechanically grinding ordinary ferrite ingots are unsatisfactory for increasing the filling ratio with the ferrite particles therein for the purpose of increasing the magnetic permeability of the resulting resin. Specifically, it is necessary to optimize the shape and the particle size of ferrite particles to be in a resin composition for semiconductor encapsulation as a filler therein, and to lower the ionic impurity content of the ferrite particles for increasing the reliability of resin-encapsulated semiconductor devices.

The invention has been made in consideration of the situation as above, and its object is to provide spherical sintered ferrite particles useful as a filler for a resin composition for semiconductor encapsulation, to provide a resin composition for semiconductor encapsulation comprising it, which has good electromagnetic wave shieldability, good moldability and high reliability, and to provide a semiconductor device encapsulated with the resin composition.

### Means for Solving the Problems

To attain the object as above, the present invention has the following constitutions.
1. Spherical sintered ferrite particles having the following properties (a) to (d):
   (a) the soluble ion content of the particles is 5 ppm or less;
   (b) the mean particle size of the particles is from 10 to 50 µm;
   (c) the crystal structure of the particles by X-ray diffractiometry is a spinel structure;
   (d) the particle size distribution of the spherical sintered ferrite particles has a peak in each of a particle size range of from 5 to 15 µm and a particle size range of from 20 to 50 µm.
2. The spherical sintered ferrite particles of item 1, which are an oxide of Fe and at least one metal element M selected from the group consisting of Mg, Zn, Ni, Mn and Cu.
3. The spherical sintered ferrite particles of item 2, wherein the molar ratio of the metal element M to Fe (M/Fe) constituting the spherical sintered ferrite particles is within a range of M/Fe = 1/1.57 to 1/2.17.
4. The spherical sintered ferrite particles of any one of items 1 to 3, which have a specific surface area by a BET method of from 0.02 to 0.1 m²/g.
5. The spherical sintered ferrite particles of any one of items 1 to 4, which have a pore volume by a mercury penetration method of 0.2 liter/kg or less.
6. A resin composition for semiconductor encapsulation, which comprises a filler containing the spherical sintered ferrite particles of any one of items 1 to 5, and silica particles.
7. The resin composition for semiconductor encapsulation of item 6, wherein the proportion of the filler is from 65 to 80 % by volume of the resin composition.
8. The resin composition for semiconductor encapsulation of item 6 or 7, wherein the proportion of the spherical sintered ferrite particles in the filler is at least 50 % by volume of the filler.
9. The resin composition for semiconductor encapsulation of item 8, wherein the blend constitution of the filler meets the following (d1) to (d3):
   (d1) the silica particles having a mean particle size of from 5 to 15 µm account for from 4 to 30 % by volume of the filler;
   (d2) the spherical sintered ferrite particles having a mean particle size of from 20 to 50 µm account for from 50 to 93 % by volume of the filler;
   (d3) the silica particles having a mean particle size of from 0.2 to 2 µm account for from 3 to 30 % by volume of the filler.
10. The resin composition for semiconductor encapsulation of item 8, wherein the blend constitution of the filler meets the following (d4) to (d6):
   (d4) the spherical sintered ferrite particles having a mean particle size of from 5 to 15 µm account for from 4 to 30 % by volume of the filler;
   (d5) the spherical sintered ferrite particles having a mean particle size of from 20 to 50 µm account for from 50 to 93 % by volume of the filler;
   (d6) the silica particles having a mean particle size of from 0.2 to 2 µm account for from 3 to 30 % by volume of the filler.
11. The resin composition for semiconductor encapsulation of any one of items 6 to 10, wherein the silica particles are spherical silica particles.
12. The resin composition for semiconductor encapsulation of any one of items 6 to 11, which contains an epoxy resin and a phenolic resin-based curing agent.
13. The resin composition for semiconductor encapsulation of item 12, which contains a curing accelerator along with the epoxy resin and the phenolic resin-based curing agent.
14. A semiconductor device produced by encapsulating a semiconductor element with the resin composition for semiconductor encapsulation of any one of items 6 to 13.

For the purpose of obtaining a resin composition to be an encapsulation material which has good electromagnetic wave shieldability and has good moldability and high reliability, we, the present inventors have made assiduous studies of essentially the constitutive components of the encapsulation material. We have specifically noted a spinel-type ferrite which has heretofore been used for imparting electromagnetic wave shieldability to encapsulation materials, and have made a series of studies for obtaining a spinel-type ferrite material having good moldability and high reliability and having good electromagnetic wave shieldability. As a result, we have found that, when spherical sintere ferrite particles having the properties (a) to (d) are used in a resin composition, then the resin composition may effectively express the excellent electromagnetic wave shieldability that the spherical sintered ferrite particles have, that the resin composition may ensure the reliability necessary and indispensable for recent encapsulation materials, that the resin composition may have a low melt viscosity while having a high filling ratio of the filler component therein, that the resin composition may have an increased mechanical strength of the cured product thereof, and that the resin composition may have good moldability; and on the basis of these findings, we have reached the present invention.

### Effect of the invention

As above, the invention provides spherical sintered ferrite particles having the above-mentioned properties (a) to (d) and to provide a resin composition for semiconductor encapsulation that contains a filler comprising the specific, spherical sintered ferrite particles and silica particles. Accordingly, the resin composition has low viscosity and good flowability and has good electromagnetic shieldability; and when the resin composition is used as an encapsulation material, then the resulting semiconductor device has good EMC characteristic.

Since the spherical sintered ferrite particles have, in addition to the properties (a) to (c), an additional property (d) that the particle size distribution thereof has a peak in each of a particle size range of from 5 to 15 µm and a particle size range of from 20 to 50 µm, their fillability is further improved and they have much better flowability and more excellent electromagnetic wave shieldability.

When the spherical sintered ferrite particles have a specific surface area by a BET method of from 0.02 to 0.1 m²/g, then they may have further better flowability.

When the spherical sintered ferrite particles have a pore volume by a mercury penetration method of 0.2 liter/kg or less, then they may have further better flowability.

### Brief Description of the Drawings

Fig. 1 is a cross-sectional view showing one example of the semiconductor device of the invention.
Fig. 2 is a cross-sectional view showing another example of the semiconductor device of the invention.
Fig. 3 is a particle size distribution curve of the spherical sintered ferrite particles used in Example 5.

### Description of Reference Numerals

- 10 and 20: Semiconductor Device
- 11 and 21: Substrate
- 14 and 22: Semiconductor Element
- 16 and 24: Cured Product

### Best Mode for Carrying out the Invention

In the invention, specific spherical sintered ferrite particles are obtained, and the most characteristic feature of the invention is that the specific spherical sintered ferrite particles are used in the resin composition for semiconductor encapsulation of the invention. For example, the resin composition may be prepared by formulating an epoxy resin and a phenolic resin-based curing agent, and additionally a curing accelerator and a silica powder, and in general, it is in the form of powder or tablets produced by tabletting it.

For the specific spherical sintered ferrite particles, the starting materials are washed with water, then sintered in spheres and thereafter further washed with water; or after sintered in spheres, they may be fully washed to thereby reduce the soluble ion content of the resulting particles to at most 5 ppm. Preferably, the soluble ion content is reduced to at most 1 ppm. Thus reducing the soluble ion content to the lowermost limit may increase the reliability of the resin composition for semiconductor encapsulation that comprises the resulting particles. Specific examples of the soluble ion include Na⁺, PO₄⁻³, and Cl⁻. In case where the soluble ion content is lower than the detection limit, then it is expressed as 0 ppm, and the total amount of the detected ions is computed.

The crystal structure by X-ray diffractiometry of the specific spherical sintered ferrite particles is a spinel structure. Recently, the operating frequency of semiconductor devices is over a level of 1 GHz, and semiconductor devices must be shielded from unnecessary radio waves of higher frequency. Having such a spinel structure, the ferrite particles may satisfy this requirement. Preferably, the spherical sintered ferrite particles are an oxide of at least one metal element M selected from the group consisting of Mg, Zn, Ni, Mn and Cu, with Fe. Specifically, this is because the electrical resistance of the material for semiconductor encapsulation is required to as high as possible. Also preferably, regarding the composition of the spherical sintered ferrite particles, the molar ratio of the metal element M to Fe constituting the particles is within a range of M/Fe = 1/1.57 to 1/2.17. Specifically, when the molar ratio of the two oversteps the above range, then the particles could not be sufficiently ferritized and could hardly have satisfactory magnetic characteristics. On the other hand, when the form of the sintered ferrite particles is not spherical, for example, when the particles have various shapes, then the viscosity of the resin composition may increase and the flowability thereof may worsen.

Preferably, the spherical sintered ferrite particles have a specific surface area by a BET method of from 0.02 to 0.1 m²/g. Also preferably, the particles have a pore volume by a mercury penetration method of 0.2 liter/kg or less. Having such a specific surface area and such a pore volume, the spherical sintered ferrite particles may have an increased degree of sintering and their surface may be smoothed, and therefore the flowability of the resin composition containing them in encapsulation of semiconductor elements is increased. Further, since the number of the pores in the particles is small, it is easy to remove soluble ions from the particles by washing them to a level of 5 ppm or less.

The mean particle size of the specific spherical sintered ferrite particles of the invention must fall within a range of from 10 to 50 µm, more preferably from 15 to 40 µm. Even more preferably, particles having a particle size of 63 µm or more do not substantially exist in the specific spherical sintered ferrite particles of the invention. In order that the resin composition for semiconductor encapsulation of the invention may contain the ferrite particles in an increased filling ratio and may have good flowability, and in order that the electromagnetic characteristic of the resin composition, µ" at 1 GHz thereof could be kept high, the particle size distribution of the ferrite particles has a peak within a particle size range of from 5 to 15 µm and a peak within a particle size range of from 20 to 50 µm. Preferably, the spherical sintered ferrite particles to be in the resin composition may have a peak at a particle size of around 10 µm and a peak at a particle size of around 30 µm. For obtaining the spherical sintered ferrite particles having such two peaks in the particle size distribution thereof, for example, herein employable is a method of mixing two types of spherical sintered ferrite particles, or that is, spherical sintered ferrite particles having a mean particle size of from 5 to 15 µm and spherical sintered ferrite particles having a mean particle size of from 20 to 50 µm. The spherical sintered ferrite particles having a particle size of around 10 µm may have a high µ" at 1 GHz, and they may be effective for improving the electromagnetic wave shieldability of the resin composition for semiconductor encapsulation containing them. The mean particle size and the particle size distribution of the specific spherical sintered ferrite particles mentioned above may be determined, for example, by the use of a laser-diffractiometric particle size analyser.

The specific spherical sintered ferrite particles may be produced, for example, as follows: First described is a method of preparing a starting ferrite powder. Starting materials for it are weighed to be a desired composition, and mixed with stirring in an aqueous solvent to give an aqueous dispersion slurry having a slurry concentration of from 60 to 90 % by weight, and then the slurry is dried by spraying, and thereafter this is heated at 800 to 1300°C or so to produce spherical sintered ferrite particles. The resulting spherical sintered ferrite particles are washed by stirring them in pure water having an electroconductivity of at most 1 µS/cm in a ratio by volume of about 1/30 (particles/water), for about 30 minutes, and then dried to produce the intended, specific spherical sintered ferrite particles.

The starting ferrite powder that is to be the source of the constitutive elements of the specific spherical sintered ferrite particles of the invention may be an oxide, a hydroxide an oxalate or a carbonate with any of Mg, Zn, Ni, Mn, Cu. The Fe element source may be iron oxide. These element sources may be mixed in a ratio to give the intended ferrite composition.

Regarding the particle morphology thereof, the particles of the starting ferrite powder may have any morphology of cubic, polyhedral, acicular or tabular forms. Preferably, the mean particle size of the starting ferrite powder is from 0.01 to 5.0 µm, more preferably from 0.1 to 2.0 µm. When the size is smaller than 0.01 µm, then the slurry viscosity may be high and accidents may happen in spraying and drying the slurry. On the other hand, when the size is larger than 5.0 µm, then the surface roughness of the sintered product may increase and the specific surface area thereof may be too large with the result that the filling ratio of the particles in resin compositions could not increase.

In the process of producing the specific spherical sintered ferrite particles, a anticoagulant may be used in the slurry formation step. The anticoagulant may be ordinary surfactant, preferably having a functional group capable of binding to the hydroxyl group that the surfaces of inorganic compound particles and sintered ferrite particles may have. More specifically, it includes sodium polycarboxylates, anionic ammonium polycarboxylates, sodium naphthalenesulfonate. In consideration of the residues of ionic impurities after firing, preferably used herein is a 40 % solution of an anionic ammonium polycarboxylate.

Another production method is described. The starting ferrite powder as above is weighed to be a desired composition, then stirred and mixed in a dry or wet mixing mode, primary-sintered at 800 to 900°C, and then dry-ground or wet-ground to give ferrite crystal particles of from 0.1 to 5.0 µm in size. Next, a slurry that contains the ferrite crystal particles is processed to give an aqueous dispersion slurry having a slurry concentration of from 60 to 90 % by weight, then this is dried by spraying, and thereafter heated at 900 to 1300°C to give spherical sintered ferrite particles. The resulting spherical sintered ferrite particles are washed by stirring them in pure water having an electroconductivity of at most 1 µS/cm in a ratio by volume for dilution of about 1/30 (particles/water), for about 30 minutes, and then dried to produce the intended spherical sintered ferrite particles of the invention. In the slurry formation step, the same anticoagulant as that mentioned hereinabove in the production of the starting ferrite powder may also be used.

The ferrite crystal particles may have any particle morphology of cubic, polyhedral, acicular or tabular forms. Preferably, the mean particle size of the ferrite crystal particles is from 0.01 to 5.0 µm, more preferably from 0.2 to 3.0 µm. When the size is smaller than 0.01 µm, then the slurry viscosity may be high and accidents may happen in spraying and drying the slurry. On the other hand, when the size is larger than 5.0 µm, then the surface roughness of the sintered product may increase and the specific surface area thereof may be too large with the result that the filling ratio of the particles in resin compositions could not increase.

In producing the spherical sintered ferrite particles of the invention, the slurry is preferably dried by spraying at a slurry concentration of from 50 to 90 % by weight, more preferably from 50 to 80 % by weight. When the concentration is lower than 50 % by weight, then the pore volume of the resulting particles may increase; but when larger than 90 % by weight, then the slurry viscosity may increase and the resulting particles could hardly keep their spherical form, and in addition, the particle size of the particles may be difficult to control.

Though depending on the ferrite composition thereof, the particles may be fired at a temperature of from 800 to 1300°C or so for 1 to 8 hours in the invention. When the particles are fired at a temperature lower than 800°C, then they may be insufficiently ferritized; but when higher than 1300°C, then the sintered particles may fuse together and much thickened and aggregated particles may increase.

Regarding the blend ratio of the specific spherical sintered ferrite particles in the resin composition for semiconductor encapsulation, the imaginarypart µ" of the complex magnetic permeability of the cured product of the resin composition must be large in order that the cured resin could have an increased electromagnetic wave shielding effect; and for this, the blend ratio of the spherical sintered ferrite particles in the resin composition is preferably at least 32.5 % by volume of the resin composition, more preferably at least 40 % by volume. The uppermost limit of the blend ratio is generally 80 % by volume or so. The uppermost limit is generally within a range within which the flowability of the resin composition could be ensured. If the blend ratio oversteps the uppermost limit, then the flowability of the resin composition may lower and the resin composition may be difficult to work.

As so mentioned hereinabove, the most characteristic feature of the resin composition for semiconductor encapsulation of the invention is that it contains the specific spherical sintered ferrite particles; and the resin compositions may contain, for example, an epoxy resin and a phenolic resin-based curing agent optionally along with a curing accelerator and a silica powder.

Not specifically defined, the epoxy resin may be any conventional known one that is solid at room temperature (25°C), including, for example, a biphenyl-type epoxy resin, a phenol-novolak-type epoxy resin, a cresol-novolak-type epoxy resin. One or more of these may be in the composition either singly or as combined.

Also not specifically defined, the phenolic resin-based curing agent may be any conventional known one that acts as a curing agent for the epoxy resin and is solid at room temperature (25°C), including, for example, phenol-novolak, cresol-novolak, bisphenol A-type novolak, naphthol-novolak and phenol-aralkyl resins. One or more of these may be in the composition either singly or as combined.

The blend ratio of the epoxy resin and the phenolic resin-based curing agent may be so designed that the hydroxyl equivalent in the phenolic resin to one equivalent of the epoxy group in the epoxy resin could be from 0. 5 to 1.6, more preferably from 0.8 to 1.2.

Not specifically defined, the curing accelerator may also be any conventional known one, including, for example, tertiary amines such as 1,8-diazabicyclo(5,4,O)undecene-7, triethylenediamine; imidazoles such as 2-methylimidazole; and phosphorus-containing curing accelerators such as triphenylphosphine, tetraphenylphosphonium tetraphenylborate. One or more of these may be in the composition either singly or as combined.

The amount of the curing accelerator to be in the resin composition may be generally from 0.5 to 10 parts by weight (hereinafter simplified to "parts") relative to 100 parts of the phenolic resin-based curing agent therein.

The resin composition for semiconductor encapsulation of the invention may contain, as a filler along with the above-mentioned spherical sintered ferrite particles, silica particles that are heretofore used as a material for semiconductor encapsulation for reducing burrs in molding. Not specifically defined, the blend ratio of the spherical sintered ferrite particles to the silica particles is preferably so designed that the proportion of the spherical sintered ferrite particles is larger for increasing the electromagnetic wave shieldability of the resin composition. More specifically, the blend ratio of the spherical sintered ferrite particles to the silica particles is preferably such that the proportion of the spherical sintered ferrite particles may be at least 50 % by volume of the whole filler (spherical sintered ferrite particles and silica particles). Also preferably, the total volume of the spherical sintered ferriteparticles and the silica particles is from 65 to 80 % by volume of the resin composition. When the total volume is smaller than 65 % by volume, then the linear expansion coefficient of the resin composition for semiconductor encapsulation may increase with the result that the cured resin may crack in thermal cycles owing to the difference in the linear expansion coefficients between the cured resin and semiconductor elements. On the other hand, when the total volume is larger than 80 % by volume, then the flowability of the resin composition for semiconductor encapsulation may lower and the resin composition could hardly encapsulate semiconductor elements with the result that the metal wires to bond semiconductor elements and electrodes may be deformed or broken.

The silica particles for use herein preferably have a mean particle size of from 1 to 40 µm and a largest particle size of at most 200 µm, more preferably a larges particle size of at most 100 µm, even more preferably at most 63 µm. Still more preferably, silica particles having a mean particle size of from 5 to 15 µm and silica particles having a mean particle size of from 0.2 to 2 µm are combined for use herein. Having the constitution makes it possible to increase the filling ratio of the spherical sintered ferrite particles in the resin composition and to increase the flowability of the resin composition. Describing more in detail, it is desirable that the silica particles having a mean particle size of from 5 to 15 µm account for from 4 to 30 % by volume of the filler, that the spherical sintered ferrite particles having a mean particle size of from 20 to 50 µm account for from 50 to 93 % by volume of the filler, and that the silica particles having a mean particle size of from 0.2 to 2 µm account for from 3 to 30 % by volume of the filler. A part or all of the silica particles having a mean particle size of from 5 to 15 µm may be replaced with the spherical sintered ferrite particles, or that is, they may be replaced with the spherical sintered ferrite particles having a mean particle size of from 5 to 15 µm whereby the electromagnetic wave shieldability of the resin composition may be further enhanced. Like that of the above-mentioned, specific spherical sintered ferrite particles, the mean particle size of the silica particles may be determined, for example, by the use of a laser-diffractiometric particle size analyser.

The silica particles may be, for example, spherical fused silica powder, ground silica powder, pulverized silica powder. Especially preferred is spherical fused silica powder, as effective for reducing the melt viscosity of the resin composition for semiconductor encapsulation containing it.

Depending on the use of semiconductor devices and the service environment for them, the resin composition for semiconductor encapsulation of the invention may contain any other filler added thereto. The additional filler includes, for example, calcium carbonate powder, titanium white, alumina powder, silicon nitride powder; and one or more of these may be in the composition either singly or as combined.

In addition, the resin composition for semiconductor encapsulation may optionally contain any other additives such as stress reducer, pigment, lubricant, coupling agent and flame retardant, if desired.

The stress reducer includes silicone compounds such as poly(ethylene glycol)-branched polydimethylsiloxane, and acrylonitrile-butadiene rubber.

The pigment includes carbon black, titanium oxide.

The lubricant includes polyethylene wax, carnauba wax, fatty acid salts.

The coupling agent includes silane-coupling agents such as γ-glycidoxypropyltrimethoxysilane, β-(3,4-epoxycyclohexyl)ethyltrimethoxysilane.

For the flame retardant, a bromoepoxy resin may be used, optionally combined with a flame retardation promoter such as antimony trioxide.

Apart from the above flame retardant, also employable herein are metal hydroxides of the following formula (1). The metal hydroxides have a polyhedral crystal form, differing from conventional hexahedral tabular crystal forms or thin tabular crystal forms such as flaky forms. More specifically, the metal hydroxides have granular crystal forms approximated to more three-dimensional and spherical forms, for example, having nearly dodecahedral, nearly octahedral or nearly tetrahedral forms, as both the longitudinal side and the lateral side crystal growth of the metal hydroxides is large in the thickness direction thereof (c-axis direction),for example, tabular crystals of metal hydroxides have grown in the thickness direction thereof (c-axis direction) therefore having the polyhedral forms as above.

M₁₋ₓQₓ(OH)₂ (1)

In formula (1), M is at least one metal atom selected from a group consisting of Mg, Ca, Sn and Ti; Q is at least one metal atom selected from a group consisting of Mn, Fe, Co, Ni, Cu and Zn; and x is a positive number of from 0.01 to 0.5.

The metal hydroxides having such polyhedral crystal forms may be produced, for example, by controlling various conditions in producing metal hydroxides in such a manner that both the longitudinal side and the lateral side crystal growth of the metal hydroxides produced could be large in the thickness direction thereof (c-axis direction) so as to have the desired polyhedral crystal forms of, for example, nearly dodecahedral, nearly octahedral or nearly tetrahedral forms. In general, mixtures of metal hydroxides having such various polyhedral crystal forms may be used herein.

Representative examples of the polyhedral metal hydroxides are Mg₁₋ₓNiₓ(OH)₂ (0.01 < x < 0.5), Mg₁₋ₓZnₓ(OH)₂ (0.01 < x < 0.5) . These metal hydroxides are commercially available, for example, as Tateho Chemical Industry' s commercial products, EcoMag.

The aspect ratio of the polyhedral metal hydroxides may be generally from 1 to 8, preferably from 1 to 7, more preferably from 1 to 4. The aspect ratio as referred to herein means a ratio of the major diameter to the minor diameter of a metal hydroxide particle. When the aspect ratio is larger than 8, then the melt viscosity of the epoxy resin composition containing the metal hydroxide may increase.

The resin composition for semiconductor encapsulation of the invention may be produced, for example, as follows: An epoxy resin, a phenolic resin-based curing agent, a curing accelerator, spherical sintered ferrite particles, and optionally an inorganic filler such as silica particles and other additives such as stress reducer, pigment, lubricant, coupling agent and flame retardant are blended in a predetermined ratio thereof. Next, the mixture is melt-kneaded and dispersed sufficiently by the use of a hot roll, an extruder, a kneader or the like, for example, at a temperature of 95 to 100°C. Then, the resulting mixture is cooled and ground, and passed through a 10-mesh screen to give a powdery resin composition for semiconductor encapsulation. If desired, it may be compression-molded into tablets. Through the process of a series of such steps, the resin composition for semiconductor encapsulation having a desired form of the invention may be obtained.

Thus obtained, the resin composition for semiconductor encapsulation may be used essentially for encapsulation of even the details of semiconductor elements of semiconductor devices, whereby the semiconductor elements may be protected from physical contact with the outside and may be shielded from electromagnetic waves.

A semiconductor device as resin-molded with the resin composition for semiconductor encapsulation of the invention is described with reference to the drawings attached hereto to show the cross-sectional view thereof.

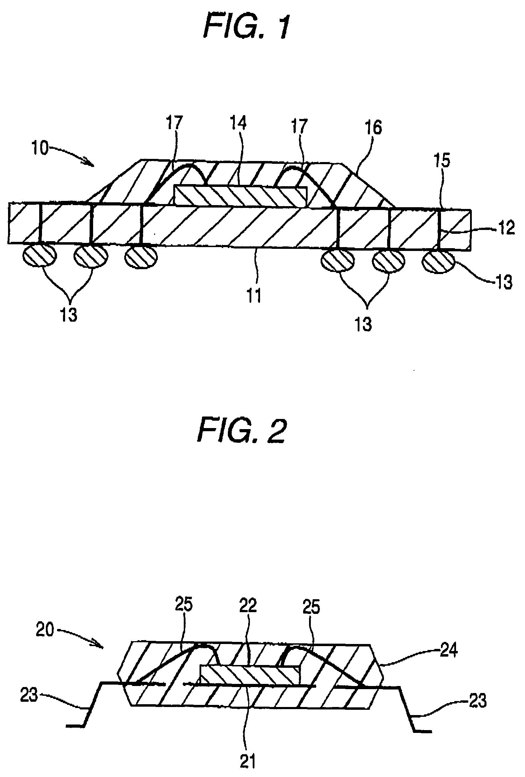

Fig. 1 shows an area-mounted semiconductor device 10, in which the through-holes of the substrate 11 are filled with wires 12. On the substrate 11, formed is an electrode 15 connected to the wires 12, and a semiconductor element 14 is mounted thereon. On the other side of the substrate 11, provided are solder balls 13, and these are electrically connected to the electrode 15 via the wires 12. The semiconductor element 14 is electrically connected to the electrode 15 via a wire bonding 17. In Fig. 1, 16 is a cured product formed of the resin composition for semiconductor encapsulation of the invention, and this encapsulates the semiconductor element 14.

Fig. 2 is a cross-sectional view of another example of a semiconductor device as resin-molded with the resin composition for semiconductor encapsulation of the invention. The semiconductor device 20 is a peripheral terminal-mounted semiconductor device, in which the semiconductor element 22 mounted on the substrate 21 is connected to the electrode 23 via the wire bonding 25. The semiconductor element 22 is wholly resin-molded with the cured product 24 on both surfaces of the substrate 21.

The semiconductor devices 10, 20 having the constitutions of Fig. 1 and Fig. 2 may be produced, for example, according to a low-pressure transfer-molding process that comprises putting a substrate 11, 21 with a semiconductor element 14, 22 mounted thereon, into a mold, then transferring a heated resin composition for semiconductor encapsulation into it under low pressure.

One example of the process is described. First, a semiconductor element 14, 22 is disposed on a substrate 11, 21, as connected to an electrode 15, 23 via a wire bonding 17, 25; and this is set in a mold comprising an upper mold part and a lower mold part. Next, a resin composition for semiconductor encapsulation is transferred into the mold under pressure by a plunger, and kept under pressure until it is cured. After cured, the upper mold part and the lower mold part are split off from each other, and thus a semiconductor device 10, 20 is obtained in which the semiconductor element 11, 22 is resin-molded with the cured product 16, 24.

In the semiconductor device 10, 20 thus obtained, the semiconductor element 14, 22 is protected from the outside, and is shielded from electromagnetic waves owing to the magnetic loss of the specific sintered ferrite powder contained in the cured product 16, 24. Accordingly, the semiconductor device is applicable to electronic devices or electronic appliances that require EMC.

The invention is described in more detail with reference to the following Examples and Comparative Examples. Examples 1 to 3 and 6 are not in accordance with the invention.

### Examples

Spherical sintered ferrites were produced as follows: Production of Spherical Sintered Ferrite a

A starting ferrite powder comprising 15 mol% of NiO, 25 mol% of ZnO, 12 mol% of CuO and 48 mol% of Fe₂O₃ and having an overall weight of 4 kg was put into a ball mill along with 2.6 kg of pure water thereinto, and stirred for 20 minutes. Next, 20 g of an anticoagulant, 40 % anionic polyammonium carboxylate (San Nopco's SN Dispersant 5468), and 10 g of a silicone defoaming agent (San Nopco's SN deformer 465) were added thereto and mixed to prepare a slurry. The resulting slurry concentration was 60 % by weight. Next, the slurry was dried by spraying to obtain a granulated powder. In the resulting powder, the starting particles aggregated into spheres, and the surface roughness level and the surface roughness profile of the starting particles were directly transferred onto the surfaces of the aggregated spheres. Next, the powder was heated at 800°C for 2 hours, and then heated (fired) at 7.000°C for 3 hours to obtain surface-smoothed, spherical sintered ferrite particles. Next, these were washed by stirring them twice each for 20 minutes in ion-exchanged water of which the overall amount was 30 times by weight of the particles, and then dewatered and dried, thereby producing spherical sintered ferrite particles a having a soluble ion content of at most 5 ppm. Through X-ray diffractiometry, the crystal structure of the particles was a spinel structure. Production of Spherical Sintered Ferrite b

A starting ferrite powder comprising 15 mol% of NiO, 25 mol% of ZnO, 12 mol% of CuO and 48 mol% of Fe₂O₃ was mixed in wet, then dewatered, and heated (primary-fired) at 800°C for 2 hours according to a conventional process. The resulting ferrite powder was ground in dry to obtain ferrite crystal particles having a mean particle size of 1 µm. Next, 4 kg of the ferrite crystal particles were taken out, and put into 1.3 kg of pure water. Next, 30 g of an anticoagulant, 40 % anionic polyammonium carboxylate (San Nopco's SN Dispersant 5468), and 16 g of a silicone defoaming agent (San Nopco's SN deformer 465) were added thereto, and mixed and stirred to prepare a slurry. The resulting slurry concentration was 75 % by weight. Next, the slurry was dried by spraying to obtain a granulated powder. In the resulting powder, the ferrite crystal particles having a mean particle size of 1 µm aggregated into spheres, and the particle size distribution of the crystal particles was directly transferred onto the spheres to be the surface roughness thereof. Next, the powder was heated (fired) at 1000°C for 3 hours to obtain surface-smoothed, spherical sintered ferrite particles. Next, these were washed by stirring them twice each for 20 minutes in ion-exchanged water of which the overall amount was 30 times by weight of the particles, and then dewatered and dried, thereby producing spherical sintered ferrite particles b having a soluble ion content of at most 5 ppm. Through X-ray diffractiometry, the crystal structure of the particles was a spinel structure. Production of Spherical Sintered Ferrite Particles c to k

The starting powder, the mean particle size and the composition of the ferrite crystal particles, the slurry concentration, and the dilution ratio of washing water were varied as in Table 1 mentioned below. Except these, the same process as that for the above-mentioned spherical sintered ferrite particles a or b was employed to produce spherical sintered ferrite particles c to k. Through X-ray diffractiometry, the crystal structure of all these particles was a spinel structure.

The spherical sintered ferrite crystals h were not washed with water. In producing the spherical sintered ferrite particles e, g, j and k, not only the slurry concentration was varied but also the mean particle size was controlled through classification.

The conditions in producing the spherical sintered ferrite particles a to k are shown in Table 1 below. The physical properties of the obtained, spherical sintered ferrite particles a to k were measured according to the methods mentioned below, and the data are shown in Table 2 below. The production method (a) in Table 1 means that the particles were produced according to the same method as that for producing the spherical sintered ferrite particles a; and the production method (b) means that the particles were produced according to the same method as that for producing the spherical sintered ferrite particles b. In the production method (a), the mean particle size indicates the particle size of the starting powder; and in the production method (b), the mean particle size indicates the mean particle size of the ferrite crystal particles.

### Observation of Particle Morphology

Using a scanning electronic microscope (Hitachi's S-800), the particle morphology was observed.

### Determination of Mean Particle Size and Particle Size Distribution

The mean particle size and the particle size distribution were determined according to a dry method, using a laser-diffractiometric particle size analyser (Sympatec's HELOS & RODOS). The particle size is based on the particle volume; and the mean particle size is a 50 % particle size. The dispersion air pressure was set at 300 Pa; the dispersion time was from 1.5 to 4 seconds; and the permeability was selected from a range of from 2 to 50 % for good reproducibility.

### Determination of Pore Volume

Using a mercury penetrator Autopore 922 (by Shimadzu), the pore volume was determined.

### Determination of BET Specific Surface Area

Using a full-automatic surface area meter, 4-Sorb by Yuasa-Ionics, the BET specific surface area was determined according to a nitrogen adsorption process.

### Determination of Soluble Ion Amount

In a Teflon® pressure container, 5 g of pure water was added to 5 g of a test sample, and sealed up. This was extracted at 121°C for 20 hours and then cooled, and the resulting extract was analyzed through ion chromatography (Nippon Dionex' s DS-500 and DS-AQ) to thereby identify the ion species and determine their amount.

### Preliminary Amendment in the Specification

**Table 1**

| Spherical Sintered Ferrite Particles | Production Condition | | | | | | | | | | |
|---|---|---|---|---|---|---|---|---|---|---|---|
| | Production Method | Mean Particle Size of Starting Powder/Crystal Particles | Composition | | | | | | | Slurry Concentration | Dilution Ratio of Washing water |
| | | | Starting Components (mol%) | | | | | | M/Fe | | |
| | | µm | Fe₂O₃ | NiO | CuO | ZnO | MnO | MgO | molar ratio | % | times by weight |
| a | (a) | 0.2 | 48.0 | 15.0 | 12.0 | 25.0 | - | - | 1/1.85 | 60 | 30 |
| b | (b) | 2.1 | 48.0 | 15.0 | 12.0 | 25.0 | - | - | 1/1.85 | 75 | 30 |
| c | (a) | 5.8 | 48.0 | 15.0 | 12.0 | 25.0 | - | - | 1/1.85 | 75 | 40 |
| d | (b) | 7.1 | 48.0 | 15.0 | 12.0 | 25.0 | - | - | 1/1.85 | 75 | 40 |
| e | (b) | 2.1 | 48.0 | 15.0 | 12.0 | 25.0 | - | - | 1/1.85 | 50 | 30 |
| f | (b) | 1.3 | 44.2 | 32.0 | 4.9 | 18.9 | - | - | 1/1.58 | 60 | 30 |
| g | (b) | 2.1 | 48.0 | 15.0 | 12.0 | 25.0 | - | - | 1/1.85 | 80 | 20 |
| h | (b) | 2.1 | 48.0 | 15.0 | 12.0 | 25.0 | - | - | 1/1.85 | 60 | - |
| i | (a) | 0.5 | 47.0 | - | - | 18.0 | 5.0 | 30.0 | 1/1.77 (47×2/(100-47)=1.77) | 70 | 30 |
| j | (a) | 0.2 | 48.0 | 15.0 | 12.0 | 25.0 | - | - | 1/1.85 | 75 | 30 |
| k | (a) | 0.2 | 48.0 | 15.0 | 12.0 | 25.0 | - | - | 1/1.85 | 50 | 30 |

**Table 2**

| Spherical Sintered Ferrite Particles | Properties of Spherical Sintered Ferrite Particles | | | | | | |
|---|---|---|---|---|---|---|---|
| | Mean Particle Size | Pore Volume | BET Specific Surface Area | Soluble Ions (ppm)* | | | |
| | µm | liter/kg | m²/g | Na⁺ | PO₄⁻³ | Cl⁻ | total |
| a | 27 | 0.035 | 0.03 | 0 | 0 | 0 | 0 |
| b | 28 | 0.040 | 0.03 | 0 | 0 | 0 | 0 |
| c | 30 | 0.26 | 0.24 | 4 | 3 | 2 | 9 |
| d | 32 | 0.28 | 0.22 | 4 | 2 | 3 | 9 |
| e | 9 | 0.020 | 0.04 | 0 | 0 | 0 | 0 |
| f | 28 | 0.032 | 0.03 | 0 | 0 | 0 | 0 |
| g | 53 | 0.045 | 0.02 | 1 | 0 | 0 | 1 |
| h | 28 | 0.032 | 0.02 | 12 | 8 | 9 | 29 |
| i | 28 | 0.036 | 0.02 | 0 | 0 | 0 | 0 |
| j | 40 | 0.025 | 0.03 | 0 | 0 | 0 | 0 |
| k | 12 | 0.039 | 0.09 | 0 | 0 | 0 | 0 |

| | | | | | | | |
|---|---|---|---|---|---|---|---|
| *: The value lower than the detection limit is 0; and the data are summed up to be the total. | | | | | | | |

### Examples 1 to 8, Comparative Examples 1 to 6

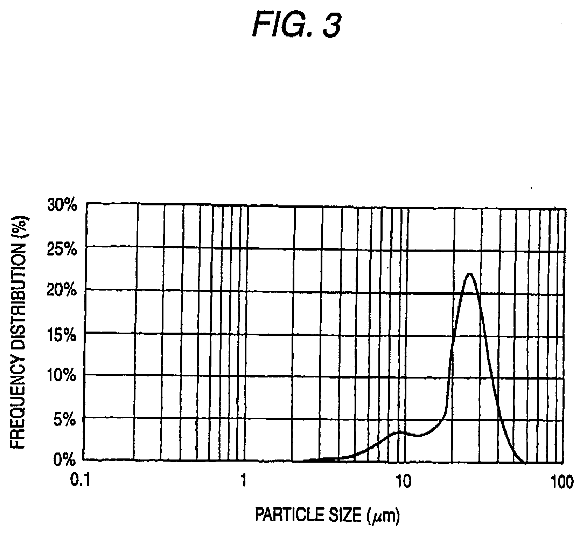

Using biphenyl-type epoxy resin (softening point 105°C, epoxy equivalent 192), phenolaralkyl resin (softening point 60°C, hydroxyl equivalent 169), a flame retardant of bromobisphenol A-type epoxy resin (softening point 77°C, epoxy equivalent 465), antimony trioxide, tetraphenylphosphonium tetraphenylborate, carbon black, a silane coupling agent of γ-glycidoxypropyltrimethoxysilane, polyethylene wax, spherical silica powder α (spherical fused silica, mean particle size 8. 0 µm, largest particle size 9.0 µm), and spherical silica powder β (spherical fused silica, mean particle size 1.5 µm, largest particle size 1.9 µm), and using the above-mentioned spherical sintered ferrite a to k, these were blended in a ratio as in Table 3 and Table 4 below. In Examples 4, 5, 7, 8, two types of spherical sintered ferrite particles each having a different mean particle size were previously mixed and used. The particle size distribution of the mixed spherical sintered ferrite particles in Example 5 is shown in Fig. 3. In Fig. 3, peaks are seen at around 10 µm and around 30 µm. Similarly, the particle size distribution of the particles in Examples 4, 7 and 8 was also determined. As a result, in Example 4, the particle size distribution had a peak at around 10 µm and around 30 µm. In Example 7, the particle size distribution had a peak at around 12 µm and around 40 µm. In Example 8, the particle size distribution had a peak at around 12 µm and around 30 µm.

Next, the mixture was melt-mixed with a hot roll heated at 85 to 110°C, for 3 minutes, and then cooled, and thereafter passed through a 10-mesh screen to produce a powdery resin composition for semiconductor encapsulation.

**Table 3**

| | | Filler Constitution in Resin Composition for Semiconductor Encapsulation | | | | | | | | | | | | | | |
|---|---|---|---|---|---|---|---|---|---|---|---|---|---|---|---|---|
| | | Spherical Sintered Ferrite Particles (vol.%) | | | | | | | | | | | | Spherical Silica (viol.%) | | |
| | | a | b | c | d | e | f | g | h | i | j | k | total | α | β | total |
| | 1 | 40 | - | - | - | - | - | - | - | - | - | - | 40 | 8.6 | 17.4 | 26.0 |
| | 2 | - | 60 | - | - | - | - | - | - | - | - | - | 60 | 3.3 | 6.7 | 10.0 |
| | 3 | - | - | - | - | - | 40 | - | - | - | - | - | 40 | 8.6 | 17.4 | 26.0 |
| Example | 4 | - | 40 | - | - | 20 | - | - | - | - | - | - | 60 | - | 6.7 | 6.7 |
| | 5 | - | 56 | - | - | 10 | - | - | - | - | - | - | 66 | - | 4.0 | 4.0 |
| | 6 | - | - | - | - | - | - | - | - | 40 | - | - | 40 | 8.6 | 17,4 | 26.0 |
| | 7 | - | - | - | - | - | - | - | - | - | 35 | 15 | 50 | - | 16.0 | 16.0 |
| | 8 | - | 43 | - | - | - | - | - | - | - | - | 13 | 56 | - | 15.0 | 15.0 |

**Table 4**

| | | Filler Constitution in Resin Composition for Semiconductor Encapsulation | | | | | | | | | | | | | | |
|---|---|---|---|---|---|---|---|---|---|---|---|---|---|---|---|---|
| | | Spherical Sintered Ferrite Particles (vol.%) | | | | | | | | | | | | Spherical Silica (vol.%) | | |
| | | a | b | c | d | e | f | g | h | i | j | k | total | α | β | total |
| | 1 | - | - | 40 | - | - | - | - | - | - | - | - | 40 | 8.6 | 17.4 | 26.0 |
| | 2 | - | - | - | 40 | - | - | - | - | - | - | - | 40 | 8.6 | 17.4 | 26.0 |
| Comparative Example | 3 | - | 70 | - | - | - | - | - | - | - | - | - | 70 | - | - | - |
| | 4 | - | - | - | - | - | - | 40 | - | - | - | - | 40 | 8.6 | 17.4 | 26.0 |
| | 5 | - | - | - | - | - | - | - | 40 | - | - | - | 40 | 8.6 | 17.4 | 26.0 |
| | 6 | - | 32 | - | - | - | - | - | - | - | - | - | 32 | - | - | - |

### Formation of Test Pieces

Molded samples for measuring the magnetic property and the dielectric property thereof were formed as follows: The above-mentioned, powdery resin composition for semiconductor encapsulation was molded into tablets having a diameter of 35 mm under a condition of molding pressure 6.86 MPa x mold temperature 175°C x molding time 2 minutes, and then cured under a condition of temperature 175°C x 5 hours. The thus-molded tablets were cut into cylindrical doughnut-shaped test pieces having an outer diameter of 7 mm, an inner diameter of 3 mm and a thickness of 2 mm, using an ultrasonic cutter.

### Determination of Magnetic Property and Dielectric Property

The doughnut-shaped test piece was set on Hewlett-Packard's Network Analyzer 8702D, and its magnetic property and dielectric property were determined according to a coaxial tube process under a condition of 1 GHz.

### Determination of Melt Viscosity

Using a vertical flow tester (Shimadzu's Model CFT500), the melt viscosity of the powdery resin composition for semiconductor encapsulation was determined at 175°C.

### Determination of Molding Burr

Using a mold for determination of molding burr (with a clearance of from 5 to 20 µm), the length of the resin burr having leaked out of the cavity was measured with calipers.

### Accelerated Reliability Test

Using the powdery resin composition for semiconductor encapsulation, a semiconductor element was transfer-molded (condition: 175°C x 2 minutes, 175°C x 5 hours post-curing) to fabricate a semiconductor device. The semiconductor device (package) is a 16-pin dual in-line package (DIP), in which the semiconductor element was mounted on Si via an insulating film, with aluminium wiring formed thereon. Thus fabricated, 10 semiconductor device samples of each of Examples and Comparative Examples were subjected to a pressure cooker bias test (PCBT). In PCBT, a bias voltage of 5 V was applied to the sample in a high-temperature high-humidity tank of 130°C x 85 % RH, and the time taken until the aluminium wiring broke was determined. The samples for which more than 100 hours were taken before 50 % of the semiconductor element wiring broke are good (A); those for which less than 100 hours were taken before 50 % of the semiconductor element wiring broke are not good (B); and those for which less than 40 hours were taken before 50 % of the semiconductor element wiring broke are worse (C).

The test results of the samples are given in Table 5 and Table 6 below.

**Table 5**

| | | Complex Magnetic Permeability µ" (1 GHz) | Melt Viscosity (dPa·s/175°C) | Molding Burr (mm) | Accelerated Reliability Test |
|---|---|---|---|---|---|
| | 1 | 1.3 | 325 | 2 mm or less | A |
| | 2 | 2.7 | 343 | 2 mm or less | A |
| | 3 | 1.3 | 330 | 2 mm or less | A |
| Example | 4 | 3.0 | 361 | 2 mm or less | A |
| | 5 | 3.2 | 390 | 2 mm or less | A |
| | 6 | 1.1 | 335 | 2 mm or less | A |
| | 7 | 2.1 | 330 | 2 mm or less | A |
| | 8 | 2.5 | 330 | 2 mm or less | A |

**Table 6**

| | | Complex Magnetic Permeability µ" (1 GHz) | Melt Viscosity (dPa·s/175°C) | Molding Burr (mm) | Accelerated Reliability Test |
|---|---|---|---|---|---|
| | 1 | 1.3 | 412 | 2 mm or less | B |
| | 2 | 1.3 | 419 | 2 mm or less | B |
| Comparative Example | 3 | 3.1 | 431 | 2 mm or less | A |
| | 4 | 1.3 | 190 | 3.5 mm | A |
| | 5 | 1.3 | 340 | 2 mm or less | C |
| | 6 | 0.9 | 141 | 5.7 mm | A |

From the results in Table 5 and Table 6 above, it is understood that the resin composition samples for semiconductor encapsulation of Examples, to which were added spherical sintered ferrite particles having a soluble ion content of at most 5 ppm, having a mean particle size of from 10 to 50 µm and having a spinel structure, have a large complex magnetic permeability and good electromagnetic wave shieldability. In addition, these resin composition samples have a suitable melt viscosity of from 300 to 400 dPa·s, therefore having good flowability. Moreover, the molding burr from these resin compositions is small, and these resin composition had a good result in the accelerated reliability test. In particular, the resin composition samples for semiconductor encapsulation of Examples 4 and 5, to which were added spherical sintered ferrite particles having a spinel structure and having, in the particle size distribution thereof, a peak in a particle size range of from 5 to 15 µm and in a particle size range of from 20 to 50 µm, have an especially large complex magnetic permeability and especially good electromagnetic wave shieldability. The resin compositions of Examples 7 and 8 have a low melt viscosity relative to the complex magnetic permeability thereof.

As opposed to these, the comparative resin composition samples, to which were added spherical sintered ferrite particles not falling within the scope of the spherical sintered ferrite particles of the invention, are problematic in that their reliability is poor, their melt viscosity is too high and they are hardly applicable to continuous production, or their melt viscosity is too low and their molding burrs are great, or they could not ensure the necessary magnetic loss µ".

### Industrial Applicability

The present invention provides spherical sintered ferrite particles useful as a filler for a resin composition for semiconductor encapsulation, a resin composition for semiconductor encapsulation comprising it, which has good electromagnetic wave shieldability, good moldability and high reliability, and a semiconductor device encapsulated with the resin composition.

## Claims

1. Spherical sintered ferrite particles having the following properties (a) to (d):
(a) the soluble ion content of the particles is 5 ppm or less;
(b) the mean particle size of the particles is from 10 to 50 µm;
(c) the crystal structure of the particles by X-ray diffractiometry is a spinel structure;
(d) the particle size distribution of the spherical sintered ferrite particles has a peak in each of a particle size range of from 5 to 15 µm and a particle size range of from 20 to 50 µm.

2. The spherical sintered ferrite particles of claim 1, which are an oxide of Fe and at least one metal element M selected from the group consisting of Mg, Zn, Ni, Mn and Cu.

3. The spherical sintered ferrite particles of claim 2, wherein the molar ratio of the metal element M to Fe (M/Fe) constituting the spherical sintered ferrite particles is within a range of M/Fe = 1/1.57 to 1/2.17.

4. The spherical sintered ferrite particles of any one of claims 1 to 3, which have a specific surface area by a BET method of from 0.02 to 0.1 m²/g.

5. The spherical sintered ferrite particles of any one of claims 1 to 4, which have a pore volume by a mercury penetration method of 0.2 liter/kg or less.

6. A resin composition for semiconductor encapsulation, which comprises a filler containing the spherical sintered ferrite particles of any one of claims 1 to 5, and silica particles.

7. The resin composition for semiconductor encapsulation of claim 6, wherein the proportion of the filler is from 65 to 80 % by volume of the resin composition.

8. The resin composition for semiconductor encapsulation of claim 6 or 7, wherein the proportion of the spherical sintered ferrite particles in the filler is at least 50 % by volume of the filler.

9. The resin composition for semiconductor encapsulation of claim 8, wherein the blend constitution of the filler meets the following (d1) to (d3):
(d1) the silica particles having a mean particle size of from 5 to 15 µm account for from 4 to 30 % by volume of the filler;
(d2) the spherical sintered ferrite particles having a mean particle size of from 20 to 50 µm account for from 50 to 93 % by volume of the filler;
(d3) the silica particles having a mean particle size of from 0.2 to 2 µm account for from 3 to 30 % by volume of the filler.

10. The resin composition for semiconductor encapsulation of claim 8, wherein the blend constitution of the filler meets the following (d4) to (d6):
(d4) the spherical sintered ferrite particles having a mean particle size of from 5 to 15 µm account for from 4 to 30 % by volume of the filler;
(d5) the spherical sintered ferrite particles having a mean particle size of from 20 to 50 µm account for from 50 to 93 % by volume of the filler;
(d6) the silica particles having a mean particle size of from 0.2 to 2 µm account for from 3 to 30 % by volume of the filler.

11. The resin composition for semiconductor encapsulation of any one of claims 6 to 10, wherein the silica particles are spherical silica particles.

12. The resin composition for semiconductor encapsulation of any one of claims 6 to 11, which contains an epoxy resin and a phenolic resin-based curing agent.

13. The resin composition for semiconductor encapsulation of claim 12, which contains a curing accelerator along with the epoxy resin and the phenolic resin-based curing agent.

14. A semiconductor device produced by encapsulating a semiconductor element with the resin composition for semiconductor encapsulation of any one of claims 6 to 13.

## Patentansprüche

1. Sphärische gesinterte Ferritpartikel mit den folgenden Eigenschaften (a) bis (d):
(a) ein lösliche Ionenanteil der Partikel beträgt 5 ppm oder weniger;
(b) die mittlere Partikelgröße beträgt von 10 bis 50 µm;
(c) die Kristallstruktur der Partikel durch Röntgenstrahldefraktometrie ist eine Spinelstruktur;
(d) die Partikelgrößenverteilung der sphärischen gesinterten Ferritpartikel weist einen Peak in jedem eines Partikelgrößenbereichs von 5 bis 15 µm und eines Partikelgrößenbereichs von 20 bis 50 µm auf.

2. Sphärische gesinterte Ferritpartikel nach Anspruch 1, welche ein Oxid von Fe und wenigstens einem Metallelement M sind, gewählt aus der Gruppe bestehend aus Mg, Zn, Ni, Mn und Cu.

3. Sphärische gesinterte Ferritpartikel nach Anspruch 2, wobei das Molverhältnis des metallischen Elements M zu Fe (M/Fe), welche die sphärischen gesinterten Ferritpartikel bilden, innerhalb eines Bereichs von M/Fe = 1/1,57 bis 1/2,17 liegt.

4. Sphärische gesinterte Ferritpartikel nach einem der Ansprüche 1 bis 3, welche eine spezifische Oberfläche durch ein BET-Verfahren von zwischen 0,02 bis 0,1 m²/g aufweisen.

5. Sphärische gesinterte Ferritpartikel nach einem der Ansprüche 1 bis 4, mit einem Porenvolumen durch ein Quecksilberpenetrationsverfahren von 0,2 l/kg oder weniger.

6. Harzzusammensetzung zur Halbleiterkapselung, umfassend einen Füllstoff enthaltend die sphärischen gesinterten Ferritpartikel nach einem der Ansprüche 1 bis 5 und Siliziumdioxidpartikel.

7. Harzzusammensetzung zur Halbleiterkapselung nach Anspruch 6, wobei der Anteil des Füllstoffes 65 bis 80 Vol.-% der Harzzusammensetzung beträgt.

8. Harzzusammensetzung zur Halbleiterkapselung nach Anspruch 6 oder 7, wobei der Anteil der sphärischen gesinterten Ferritpartikel in dem Füllstoff wenigstens 50 Vol.-% des Füllstoffes beträgt.

9. Harzzusammensetzung zur Halbleiterkapselung nach Anspruch 8, wobei die Mischungszusammensetzung des Füllstoffes die folgenden (d1) bis (d3) erfüllt:
(d1) die Siliziumdioxidpartikel mit einer mittleren Partikelgröße von 5 bis 15 µm bilden von 4 bis 30 Vol.-% des Füllstoffes;
(d2) die sphärischen gesinterten Ferritpartikel mit einer mittleren Partikelgröße von 20 bis 50 µm bilden von 50 bis 93 Vol.-% des Füllstoffes;
(d3) die Siliziumdioxidpartikel mit einer mittleren Partikelgröße von 0,2 bis 2 µm bilden 3 bis 30 Vol.-% des Füllstoffes.

10. Harzzusammensetzung zur Halbleiterkapselung nach Anspruch 8, wobei die Mischungszusammensetzung des Füllstoffes die folgenden (d4) bis (d6) erfüllt:
(d4) die sphärischen gesinterten Ferritpartikel mit einer mittleren Teilchengröße von 5 bis 15 µm bilden von 4 bis 30 Vol.-% des Füllstoffes;
(d5) die sphärischen gesinterten Ferritpartikel mit einer mittleren Partikelgröße von 20 bis 50 µm bilden von 50 bis 93 Vol.-% des Füllstoffes;
(d6) die Siliziumdioxidpartikel mit einer mittleren Partikelgröße von 0,2 bis 2 µm bilden von 3 bis 30 Vol.-% des Füllstoffes.

11. Harzzusammensetzung zur Halbleiterkapselung nach einem der Ansprüche 6 bis 10, wobei die Siliziumdioxidpartikel sphärische Siliziumdioxidpartikel sind.

12. Harzzusammensetzung zur Halbleiterkapselung nach einem der Ansprüche 6 bis 11, welche ein Epoxidharz und ein auf Phenolharz basierendes Härtemittel enthält.

13. Harzzusammensetzung zur Halbleiterkapselung nach Anspruch 12, enthaltend einen Härtebeschleuniger zusammen mit dem Epoxidharz und dem auf Phenolharz basierendem Härtemittel.

14. Halbleitereinrichtung hergestellt durch Kapseln eines Halbleiterelementes mit der Harzzusammensetzung zur Halbleiterkapselung nach einem der Ansprüche 6 bis 13.

## Revendications

1. Particules de ferrite frittées sphériques présentant les propriétés (a) à (d) suivantes :
(a) la teneur en ion soluble des particules est de 5 ppm ou inférieure ;
(b) la taille moyenne de particule des particules est de 10 à 50 µm;
(c) la structure de cristal des particules par diffractométrie aux rayons X est une structure spinelle ;
(d) la distribution de taille de particule des particules de ferrite frittées sphériques présente un pic dans chacun d'un intervalle de taille de particule de 5 à 15 µm et d'un intervalle de taille de particule de 20 à 50 µm.

2. Particules de ferrite frittées sphériques selon la revendication 1, lesquelles sont un oxyde de Fe et d'au moins un élément de métal M choisi dans le groupe constitué de Mg, Zn, Ni, Mn et Cu.

3. Particules de ferrite frittées sphériques selon la revendication 2, dans lesquelles le rapport molaire de l'élément de métal M à Fe (M/Fe) constituant les particules de ferrite frittées sphériques se trouve dans un intervalle de M/Fe = 1/1,57 à 1/2,17.

4. Particules de ferrite frittées sphériques selon l'une quelconque des revendications 1 à 3, lesquelles présentent une surface spécifique par un procédé BET de 0,02 à 0,1 m²/g.

5. Particules de ferrite frittées sphériques selon l'une quelconque des revendications 1 à 4, lesquelles présentent un volume de pore par un procédé de pénétration de mercure de 0,2 litre/kg ou inférieur.

6. Composition de résine pour une encapsulation de semiconducteur, laquelle comprend une charge contenant les particules de ferrite frittées sphériques selon l'une quelconque des revendications 1 à 5, et des particules de silice.

7. Composition de résine pour une encapsulation de semiconducteur selon la revendication 6, dans laquelle la proportion de la charge est de 65 à 80 % en volume de la composition de résine.

8. Composition de résine pour une encapsulation de semiconducteur selon la revendication 6 ou 7, dans laquelle la proportion des particules de ferrite frittées sphériques dans la charge est d'au moins 50 % en volume de la charge.

9. Composition de résine pour une encapsulation de semiconducteur selon la revendication 8, dans laquelle la constitution de combinaison de la charge répond aux (d1) à (d3) suivants :
(d1) les particules de silice présentant une taille moyenne de particule de 5 à 15 µm comptent pour de 4 à 30 % en volume de la charge ;
(d2) les particules de ferrite frittées sphériques présentant une taille moyenne de particule de 20 à 50 µm comptent pour de 50 à 93 % en volume de la charge ;
(d3) les particules de silice présentant une taille moyenne de particule de 0,2 à 2 µm comptent pour de 3 à 30 % en volume de la charge.

10. Composition de résine pour une encapsulation de semiconducteur selon la revendication 8, dans laquelle la constitution de combinaison de la charge répond aux (d4) à (d6) suivants :
(d4) les particules de ferrite frittées sphériques présentant une taille moyenne de particule de 5 à 15 µm comptent pour de 4 à 30 % en volume de la charge ;
(d5) les particules de ferrite frittées sphériques présentant une taille moyenne de particule de 20 à 50 µm comptent pour de 50 à 93 % en volume de la charge ;
(d6) les particules de silice présentant une taille moyenne de particule de 0,2 à 2 µm comptent pour de 3 à 30 % en volume de la charge.

11. Composition de résine pour une encapsulation de semiconducteur selon l'une quelconque des revendications 6 à 10, dans laquelle les particules de silice sont des particules de silice sphériques.

12. Composition de résine pour une encapsulation de semiconducteur selon l'une quelconque des revendications 6 à 11, laquelle contient une résine époxy et un agent durcissant à base de résine phénolique.

13. Composition de résine pour une encapsulation de semiconducteur selon la revendication 12, laquelle contient un accélérateur de durcissement avec la résine époxy et l'agent durcissant à base de résine phénolique.

14. Dispositif semiconducteur produit par encapsulation d'un élément semiconducteur avec la composition de résine pour une encapsulation de semiconducteur selon l'une quelconque des revendications 6 à 13.
